**Europäisches Patentamt**

**European Patent Office**

**Office européen des brevets**

(19)

(11) Veröffentlichungsnummer: **0 198 861**
**B1**

(12) EUROPÄISCHE PATENTSCHRIFT

(45) Veröffentlichungstag der Patentschrift: **18.04.90**

(21) Anmeldenummer: **85905056.9**

(22) Anmeldetag: **15.10.85**

(86) Internationale Anmeldenummer:
**PCT/DE85/00378**

(87) Internationale Veröffentlichungsnummer:
**WO 86/02738 09.05.86 Gazette 86/10**

(51) Int. Cl.⁵: **G 01 R 31/36, H 01 M 10/48**

(54) ÜBERWACHUNGSEINRICHTUNG FÜR EINE BATTERIE.

(30) Priorität: **23.10.84 DE 3438783**

(43) Veröffentlichungstag der Anmeldung:
**29.10.86 Patentblatt 86/44**

(45) Bekanntmachung des Hinweises auf die
Patenterteilung:
**18.04.90 Patentblatt 90/16**

(84) Benannte Vertragsstaaten:
**BE FR GB NL**

(56) Entgegenhaltungen:
**EP-A-0 080 164**
**DE-A-2 838 996**
**GB-A-1 262 016**
**US-A-3 808 534**

(73) Patentinhaber: Asea Brown Boveri
Aktiengesellschaft
Kallstadter Strasse 1
D-6800 Mannheim-Käfertal (DE)

(72) Erfinder: KAHLEN, Hans
Am Schlittweg 14
D-6750 Kaiserslautern (DE)

(74) Vertreter: Fritsch, Klaus et al
c/o BBC Brown Boveri Aktiengesellschaft
Zentralbereich Patente Postfach 10 03 51
D-6800 Mannheim 1 (DE)

Courier Press, Leamington Spa, England.

## Beschreibung

Die Erfindung betrifft eine Überwachungseinrichtung für eine Batterie, insbesondere eines Akkumulators mit wässrigem Elektrolyten oder einer Hochenergiebatterie, wie z. B. NaS-Batterie, mit wenigstens zwei parallel geschalteten Zweigen, die jeweils aus Zellreihen mit m+n Zellen bestehen, wobei m und n beliebige natürliche Zahlen sind.

Herkömmliche Akkumulatoren bestehen in der Regel aus einer Reihenschaltung einzelner Zellen. In einer Akkumulatorzelle sind Untersysteme parallel geschaltet, die jedoch von außen nicht zugänglich sind. Aus diesem Grunde ist für eine Batterie im normalen Anwendungsfall nur eine Reihenschaltung möglich. Bei neuartigen Batteriesystemen, wie z. B. der NaS-Batterie werden aus verschiedenen Gründen die Zellen nicht für den gesamten notwendigen Strom ausgelegt. Stattdessen werden Zellen parallel geschaltet. Mit diesen Einzelzellen ist es möglich, Reihen-, Parallel- oder Gruppenschaltungen durchzuführen.

Eine Störung in einer Zelle durch einen Kurz-schluß oder durch eine Unterbrechung oder eine Störung infolge eines Kontaktfehlers zwischen zwei Zellen ist bei einer Parallelschaltung mehrerer Zellreihen nicht unmittelbar durch Messung des Anschlußstromes oder der Anschlußspannung feststellbar. Solch eine Störung beeinträchtigt jedoch die Leistungsfähigkeit der Batterie und kann weitere Störungen an anderen Zellen nach sich ziehen, so daß das rechtzeitige Erkennen dieser Störung wünschenswert ist und in vielen Fällen gefordert werden muß. Insbesondere wird bei einem hochohmigen Zellausfall durch den Spannungsabfall der parallelgeschalteten und belasteten Zellreihen einerseits und die Ruhespannung der im gestörten Zweig liegenden und daher unbelasteten Zellen andererseits an der gestörten Zelle eine hohe negative Spannung entstehen.

Ferner muß beim Laden einer Batterie davon ausgegangen werden, daß nicht alle Zellen gleichzeitig voll geladen werden. Zellen, die mit anderen Zellen in Reihe geschaltet sind, werden auch dann noch vom Ladestrom durchflossen, wenn sie vollgeladen sind. Bei Batteriezellen mit wässrigen Elektrolyten, wie bei Bleiakkumulatoren, wird dabei die Gasungsspannung erreicht. Die Zelle kann keine weitere Energie mehr speichern. Der eingeprägte Ladestrom führt zu einer Wasserzersetzung, wodurch die zugeführte Energie abgeführt wird.

Auch bei Hochenergiebatterien wie Natrium-Schwefel-Batterien oder Lithium-Schwefel-Batterien treten Probleme auf, wenn einzelne Zellen vollgeladen sind, ohne daß das Laden der Batterie abgebrochen bzw. der Ladestrom reduziert wird. Da NaS-Zellen einen hundertprozent Coulomb Wirkungsgrad haben, begrenzt die Zelle die zuerst vollgeladen ist, den Ladevorgang. Es tritt an dieser Stelle eine höhere Ladespannung auf, die überwacht werden muß, damit diese Zelle nicht zerstört wird.

Beim Entladen einer Batterie sind aufgrund der Parameter-Streuung nicht alle Zellen gleichzeitig entladen. In einer Reihenschaltung werden alle Zellen vom gleichen Ladestrom durchflossen. Die Zelle mit der schlechtesten Kapazität ist zuerst entladen. Bei den meisten Batteriezellen erhöht sich dabei der Innenwiderstand. Der eingeprägte Entladestrom bewirkt bei entladener Zelle eine Spannungsumkehr. Dies kann bei Batterien mit wässrigen Elektrolyten, wie Bleiakkumulatoren, zur Umpolung der Platten führen und die Batterien beschädigen oder zerstören. Bei Natrium-Schwefel-Zellen führt eine Tiefentladung ebenfalls zur Beschädigung oder Zerstörung der Zel-len.

Um ein Überladen bzw. Tiefentladen von Zellen einer Batterie zu vermeiden wurden daher durch die DE-A-28 19 584 und die DE-A-28 38 996 Schaltungen angegeben, bei denen jeder in Serie geschalteten Speicherzelle oder jeder Gruppe von Speicherzellen mindestens je ein Schutzelement parallel geschaltet ist. Dies erfordert gegebenenfalls eine hohe Anzahl von Schutzelementen, deren insbesondere nachträgliche Montage sehr aufwendig ist.

Durch die DE-A-31 46 141 ist eine Überwa-chungseinrichtung für eine Batterie bekannt geworden, bei der gleiche Batteriemodule oder Teilbatterien in Reihe geschaltet sind. Es werden dabei die Spannungen über den einzelnen Teilbatterien gemessen und miteinander verglichen. Unterschiedliche Spannungen zweier Teilbatterien deuten auf eine gestörte Batterie hin. Diese Überwachungsschaltung ist im Prinzip auch auf parallel geschaltete Zellreihen anwendbar. In diesem Fall ist die Zahl der Meßleitung und der zu verwendenen Meßverstärker jedoch proportional der parallel geschalteten Zellreihen. Bei z.B. vier parallel geschalteten Zellreihen ist somit der vierfache Aufwand an Meßleitungen und der vierfache Aufwand an Meßeinrichtungen erforderlich.

Aus der EP-A-0 080 164 ist die Überwachungseinrichtung für eine Batterie bekannt. Die Überwachung der Batterie hinsichtlich Störungen während ihres Betriebs wird dadurch bewirkt, daß die Symmetrie der Batterie überwacht und ausgewertet wird. Dies geschieht dadurch, daß die Batterie aus wenigstens zwei gleichen in Reihe geschalteten Batterieteilen gebildet wird, und an den elektrischen Anschlüssen der einzelnen Batterieteile elektrische Leitungen angeschlossen sind, die mit einer Schaltungsanordnung zur Messung der Differenzspannung zwischen jeweils zwei Batterieteilen elektrisch verbunden sind. Aus der Differenz zwischen zwei Batterieteilen können Rückschlüsse auf den Zustand der Batterieteile gezogen werden.

Da die NaS-Batterie eine Hochtemperaturbatterie ist, sollten sich möglichst wenig Überwachungs- oder Meßleitungen im Batterieinneren befinden, bzw. aus dem Batterieinneren herausgeführt werden.

Aufgabe der Erfindung ist es, eine einfache Überwachungeinrichtung für Batterien mit parallelgeschalteten Zellreihen anzugeben, durch die Störungen beim Betrieb der Batterie und das Ausfallen einzelner Batteriezellen erkannt werden kann, durch die feststellbar ist, in welchen Batterieteilen sich Fehler- oder Störquellen befinden, und die ferner eine Kontrolle von Lade- und Entladungsvorgänge ermöglicht. Die geschilderten Nachteile des Standes der Technik sollen vermieden werden.

Diese Aufgabe wird erfindungsgemäß dadurch gelöst, daß in jeder der parallel geschalteten Zellreihen A, B, C, D wenigstens ein Mittelabgriff 1, 2, 3, 4 für eine Meßleitung 16, 17, 18, 19, 27, 28 jeweils zwischen der m-ten und n-ten Zelle angeschlossen ist, daß innerhalb der Batterie jeweils zwei Zellreihen A, B, C, D über jeweils zwei hochohmige Widerstandselemente 29 miteinander verbunden sind und daß der Verbindungspunkt 30, 31 der Widerstandselemente jeweils über eine weitere Meßleitung 27, 28 an der Batterie herausgeführt und mit der Schaltungsanordnung verbunden ist.

Aus der Differenzspannung können Rückschlüsse auf den Zustand der Batterieteile (Zellreihen) gezogen werden. Arbeiten beide Zellreihen und deren einzelne Zellen fehlerfrei, so ist die Differnzspannung in allen stationären Betriebszuständen null. Bei Auftreten eines Kurzschlusses in einer Zelle, einer Erhöhung des Innenwiderstandes einer Zelle, eines Kontaktfehlers zwischen zwei Zellen und bei einer Überladung oder Tiefentladung einer Zelle weicht die Differenzspannung von null ab. Aus der Höhe und Polarität der Differenzspannung sowie des jeweiligen Betriebszustandes der Batterie kann die Art des Fehlers ermittelt und der Batterieteil, in dem der Fehler auftritt, festgestellt werden.

Ein Vorteil dieser Uberwachung ist es, daß an den Eingängen des Netzverstärkers keine Spannung liegt, und damit nicht eine Spannungsdifferenz von sehr hohen Potentialunterschieden gemacht werden muß (siehe DE-A-31 46 141). Es ist somit möglich, auch bei sehr langen Zellreihen, die zu einer Batteriespannung von z. B. 200V führen, nur mit einem Spannungsabgriff je Zellreihe die Batterie zu überwachen.

Es ist zweckmäßig, in jeder der parallel geschalteten Zellreihen wenigstens einen Mittelabgriff für eine Meßleitung anzuschließen. Dies ermöglicht eine Vollüberwachung der Batterie, d. h. ein Defekt in einer beliebigen Zelle bzw. zwischen zwei beliebigen Zellen kann durch die Uberwachungseinrichtung festgestellt werden.

Im Prinzip kann der Mittelabgriff zwischen zwei beliebigen Zellen einer Zellreihe angeschlossen sein, wesentlich ist lediglich, daß alle Zellreihen mit gleichviel Zellen bestückt sind, und daß die relative Lagen der Mittelabgriffe für alle Zellreihen gleich sind. Für eine Vereinfachung der Auswertung der Differenzspannungssignale ist es jedoch von Vorteil, wenn der Mittelabgriff jeweils in der Mitte der Zellreihen angeschlossen ist, d. h. wenn m=n ist. Hierfür ist es erforderlich, daß in den Zellreihen eine gradzahlige Anzahl von Zellen hintereinander geschaltet sind.

In vorteilhafter Weise ist jede Meßleitung durch wenigstens einen gegenüber dem Innenwiderstand der Batteriezellen hochohmigen Widerstand unterteilt. Ferner ist es zweckmäßig, daß alle Meßleitungen den gleichen ohmschen Widerstandswert aufweisen, wobei sowohl die Widerstände der Meßleitungen als auch gegebenenfalls die der Widerstandselemente berücksichtigt werden.

Zur Messung der Differenzspannung sind die Meßleitungen zweier Zellreihen vorzugsweise an einen Differenzverstärker angeschlossen.

Um die Aussagefähigkeit der Differenzspannungsmeßwerte zu erhöhen, wird die Mittelabgriffsspannung einer Zellreihe mit den Mittelabgriffsspannungen mehrerer anderer Zellreihen verglichen. Hierfür wird die Meßleitung einer Zellreihe mit den ersten Eingängen mehrerer Differenzverstärker verbunden, an deren jeweils zweiten Eingang Meßleitung verschiedener anderer Zellreihen angeschlossen sind.

Um weitere Meßleitungen, die aus dem Batteriegehäuse herausgeführt werden müssen, einsparen zu können, schlägt eine weitere, vorteilhafte Ausgestaltung der Erfindung vor, innerhalb der Batterie die Meßleitungen zweier Zellreihen, in denen jeweils ein gegenüber dem Widerstandswert einer Zellreihe hochohmiges Widerstandselement liegt, miteinander zu verbinden und den Verbindungspunkt über eine weitere Meßleitung aus der Batterie herauszuführen.

Vorzugsweise sind die Ausgänge der Shaltungsanordnung zur Messung der Differenzspannung mit einem Steuer- und/oder Überwachungsschaltkreis verbunden. Dieser Steuer- oder Überwachungsschaltkreis gibt zweckmäßigerweise bei Auftreten eines Zelleffektes, bzw. bei Auftreten einer Unterbrechung zwischen zwei Zellen, ein Signal ab. Dieses Signal kann einerseits zu einer der Batterie vorgeschalteten Steuereinrichtung geführt werden und dort eine Senkung der an die Batterie angeschlossenen Last- bzw. der Ladeleistung hervorrufen. Andererseits kann das Signal für eine optische oder akkustische Anzeige herangezogen werden.

Anhand der Zeichnung, in der mehrere Ausführungsbeispiele der Erfindung gezeigt sind, sollen die Erfindung sowie weitere vorteilhafte Ausgestaltungen und Weiterbildungen näher erläutert und beschrieben werden.

Es zeigt:

Figur 1 Die Grundschaltung einer Batterie mit vier parallel geschalteten Zweigen,

Figur 2 eine Batterie gemäß Figur 1 mit vier Differenzverstärkern zur Messung von Differenzspannungen,

Figur 3 eine Batterie gemäß Figur 1 mit einem Differenzverstärker zur Messung einer Differenzspannung und

Figur 4,5 und 6 die Stromund Spannungsverteilung einer Batterie gemäß Figur 1 bei verschiedenen Zelldefekten und unterschiedlichen Belastungszuständen der Batterie.

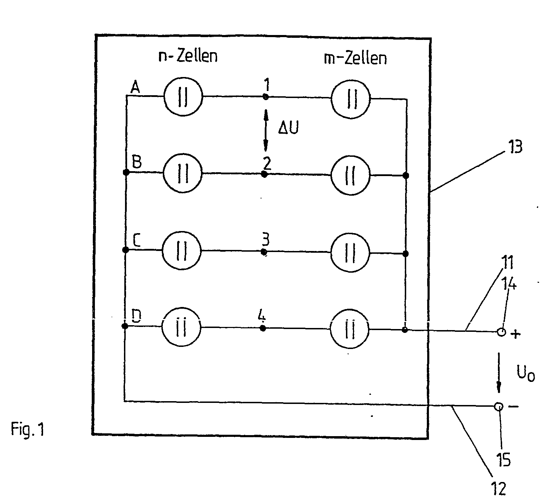

In der Figur 1 ist eine Batterie dargestellt, die aus einer Parallelschaltung von vier Zweigen besteht. Jeder der vier Zweige wird durch eine Reihenschaltung von n+m Zellen gebildet. Zwischen der n-ten und (n+1)-ten Zelle jedes Zweiges befindet sich ein Mittelabgriff 1, 2, 3, 4. Durch den Mittelabgriff 1, 2, 3, 4 wird jeder Zweig in zwei Teile unterteilt, auf deren einen Seite sich n Zellen und auf deren anderen Seite sich m Zellen befinden. Über zwei Anschlußleitungen 11, 12 ist die Batterie mit zwei außerhalb des Batteriegehauses 13 liegenden Anschlußklemmen 14, 15 verbunden.

Die Anzahl der Zellen in einem der vier Zweige der Batterie gemäß Figur 1 kann 56 betragen. Zur Überwachung wird eine Symmetrie der Batterie vorausgesetzt. Bei einem Abgriff nach n Zellen in jedem Zweig muß bei gleichem Ladezustand aller Zellen und gleichen Innenwiderständen die Differenzspannung zwischen zwei Zweigen $U=0$ sein. Bei unterschiedlichen Innenwiderständen entsteht eine vom Strom abhängige Differenzspannung. Bei Ausfall einer Zelle entsteht eine Differenzspannung bis zu $U=2$ Volt sofern jede der Zellen eine Leerlaufspannung von zwei Volt abgibt.

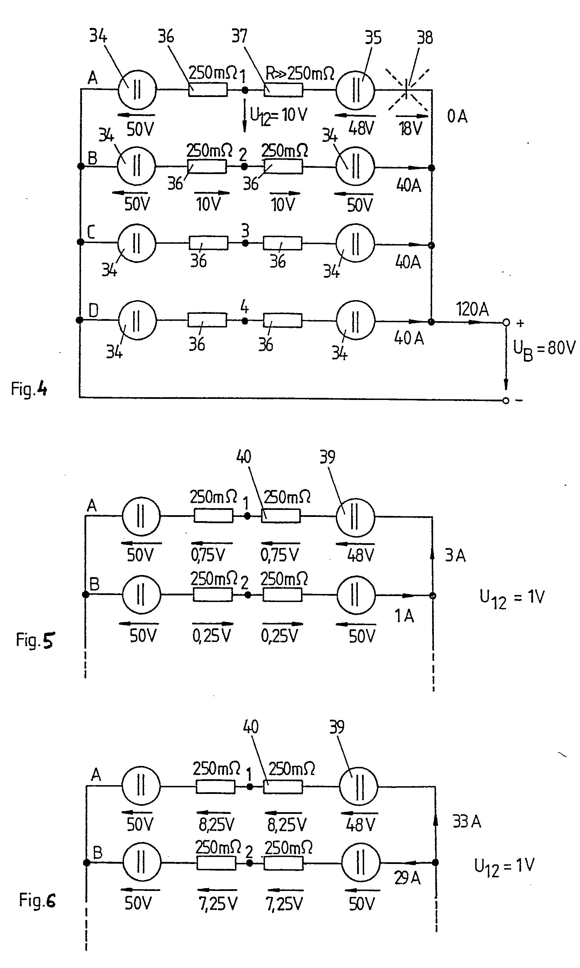

Redundanz und eine Aussage darüber, welcher Zweig gestört ist, erhält man durch eine Anordnung mit vier Differenzverstärkern, wie sie Figur 2 zeigt. Auch bei der Anordnung gemäß Figur 2 wird eine Meßleitung 16, 17, 18, 19 aus dem Batteriegehäuse 13 herausgeführt. Jede der Meßleitungen 16, 17, 18, 19 ist mit den Eingängen zweier Differenzverstärker 23, 24, 25, 26 verbunden. Die Differenzverstärker 23, 24, 25, 26 geben die Differenzspannungen zwischen den Mittelabgriffen des ersten und zweiten Zweiges ($U_{12}$), des zweiten und dritten Zweiges ($U_{23}$), des vierten und ersten Zweiges ($U_{41}$) und des dritten und vierten Zweiges ($U_{34}$) ab. Fällt im ersten Zweig, auf der rechten Seite (Pluspol) eine Zelle aus (kurzgeschlossen) dann ist $U_{12}$ größer Null und $U_{41}$ kleiner Null. Die übrigen Differenzspannungen $U_{23}$ und $U_{34}$ sind (sofern die Batterie keine weiteren Fehler aufweist) Null.

Eine minimale Anordnung, bei der nur zwei Meßleitungen 27, 28 aus dem Batteriegehäuse 13 herausgeführt werden müssen, zeigt Figur 3. Jeweils zwei Zellreihen werden über 1 kOhm-Schutzwiderstände 29 miteinander verbunden. Die Verbindungspunkte 30, 31 sind über die Meßleitungen 27, 28 mit einem Differenzverstärker 32 verbunden. Bei Ausfall einer Zelle tritt nun zwischen den Verbindungspunkten 30, 31 die halbe Differenzspannung gegenüber den bisher beschriebenen Meßschaltungen auf. Eine Aussage, welcher Zweig gestört ist, kann nicht gemacht werden. Dies ist jedoch für eine einfache Betriebsüberwachung nicht zwingend notwendig. Z. B. ist es bei der Überwachung der Traktionsbatterie in einem Fahrzeug nicht von Bedeutung, festzustellen, in welchem Zweig eine Störung vorliegt, sondern nur, daß eine Störung vorliegt.

Anhand der Figuren 4, 5, 6, soll im folgendem eine Fehlerdiskussion durchgeführt werden. Es wird beispielhaft anhand von möglichen Fehlern (hochohmiger und niederohmiger Zellausfall) für verschiedene Betriebszustände der Batterie (Belastung, Laden und stromloser Zustand) untersucht, welche Spannungen zwischen den Mittelabgriffen 1 und 2 der Zweige A und B auftreten.

Figur 4 zeigt wie Figur 1, eine Batterie, die aus vier parallel geschalteten Zweigen A, B, C, D aufgebaut ist. In jeden Zweig A, B, C, D sind zwei mal 25 Zellen in Reihe geschaltet. Zwischen diesen beiden Zellgruppen befindet sich jeweils eine Mittelabgriff 1, 2, 3, 4, der gemäß den Figuren 2 und 3 über Meßleitungen aus dem Batteriegehäuse 13 herausgeführt und einer Differenzspannungsmeßeinrichtung zugeführt ist. Die Darstellung gemäß Figur 4 entspricht einem Ersatzschaltbild der Batterie, in dem jeweils 25 Zellen zu einer EMK 34, 35 und einem gemeinsamen Innenwiderstand 36, 37 zusammengefaßt sind. Bis auf die rechte Seite des oberen Zweiges A haben alle EMK 34 die gleiche Spannung von 50 Volt (2 Volt je Zelle) und alle Innenwiderstände 36 den gleichen Wert von 250 mOhm (10 mOhm pro Zelle).

Die rechte Hälte des oberen Zweiges A soll einen Zelldefekt aufweisen, und zwar soll eine der 25 Zellen hochohmig geworden sein. Der Zelldefekt wurde zeichnerisch dadurch dargestellt, daß die defekte Zelle 38 aus der EMK 35 der übrigen 24 Zellen herausgezogen wurde. Der Innenwiderstand 37 des defekten Teilzweiges ist sehr viel größer als der Innenwiderstand 36 eines nicht defekten Teilkreises (R viel kleiner als 250 mOhm).

In Figur 4 sind ferner durch Pfeile die Spannungen angegeben, die sich beim Entladen der Batterie über den einzelnen Ersatzschaltelementen einstellen. Der Laststrom in den Anschlußleitungen 11, 12 beträgt 120 A und wird aus den drei nicht defekten Zweigen B, C, D mit je 40 A gespeist. Der defekte Zweig A trägt wegen des hochohmigen Zellausfalls nicht zum Laststrom bei (0 A). Über den Kontakten EMK 34 liegt jeweils eine Spannung von 50 Volt an. Über den intakten Innenwiderständen 36 der Zweige B, C, D fällt eine entgegengesetzt gerichtete Spannung von 10 Volt aufgrund der Strombelastung von 40 A ab. Damit ergibt sich zwischen den Anschlußklemmen 14, 15 eine Belastungsspannung von 80 Volt.

In der rechten Hälfte des oberen Zweiges A ist die Spannung der 24 intakten Zellen 48 Volt. Da in dem oberen Zweig A kein Strom fließt fällt über den Innenwiderständen 36, 37 keine Spannung ab. Ferner liegt jedoch über dem gesamten oberen Zweig A die Belastungsspannung von 80 Volt an, so daß an der hochohmig gestörten Zelle 38 die Spannung von -18 Volt liegt. Zwischen den Mittelabgriffen 1 und 2 (bzw. zwischen 1 und 3 oder 1 und 4) tritt bei Belastung der Batterie die Spannung $U_{12}=10$ Volt auf. Zwischen den Mittelabgriffen 2 und 3, 3 und 4 oder 2 und 4 herrscht keine Spannungsdifferenz.

Beim Laden der Batterie mit 120 A (was in Figur 5 nicht durch Spannungspfeile dargestellt wurde) liegt über den EMK 34, 35 die gleiche Spannung wie bei der Belastung an. Jedoch ist die Polarität über den Innenwiderständen gegenüber dem Belastungsfall umgekehrt. Die Ladespannung an den Anschlußklemmen 14, 15 beträgt 120 Volt. An der gestörten Zelle 38 liegt jetzt eine Spannung von +22 Volt an und zwischen den Meßpunkten der Mittelabgriffe 1 und 2 herrscht die Spannung von $U_{12}=-10$ Volt. Zwischen den Mittelabgriffen 2, 3 und 4 herrscht auch in diesem Betriebszustand kein Spannungsunterschied.

Im stromlosen Zustand der Batterie kann zwischen den Mittelabgriffen 1 und 2 keine Differenzspannung gemessen werden.

In Figur 5 sind die beiden oberen Zweige A, B einer Batterie dargestellt, die im wesentlichen der in Figur 4 dargestellten Batterie gleicht. Auch hier liegt in der rechten Hälfte des oberen Zweiges A eine defekte Zelle. Es handelt sich jedoch hier im Unterschied zu der defekten Zelle 38 der Figur 4 um eine solche Zelle, die keine Zellspannung abgibt. Die gestörte Zelle behält jedoch ihren Innenwiderstand von 10 mOhm bei. Daher liegt in der rechten Hälfte des oberen Zweiges A eine EMK 39 mit 48 Volt und einem Innenwiderstand 40 von 250 mOhm.

Infolge der fehlenden Zellspannung der defekten Zelle wird — im Bereich konstanter Spannung — aus den drei intakten Zweigen B, C, D ein Ausgleichsstrom in den oberen, defekten Zweig A von 3 A getrieben, wobei jeder der intakten Zweige B, C, D einen Anteil von 1 A beiträgt. Über den Innenwiderständen des Zweiges A fällt jeweils eine Spannung von 0,75 Volt ab, während über den Innenwiderständen der intakten Zweige B, C, D lediglich eine Spannung von 0,25 Volt liegt. Damit ergibt sich eine Spannung zwischen den Mittelabgriffen 1 und 2 von $U_{12}=1$ Volt.

Diese Spannung ist unabhängig von der Betriebsart der Batterie. Bei Belastung der Batterie (was nicht durch die Spannungspfeile dargestellt wurde) mit 120 A übernimmt der gestörte Zweig A den Teilstrom 27 A und die intakten Zweige B, C, D je 31 A. Zwischen den Mittelabgriffen 1 und 2 ändert sich die Spannungsdifferenz von $U_{12}=1$ Volt nicht (Überlagerungssatz).

Auch beim Laden der Batterie mit 120 A ändern sich die Verhältnisse nicht, wie der Figur 6 entnehmbar ist. Der gestörte Kreis übernimmt den Teilstrom von 33 A und die intakten Zweige B, C, D je 29 A.

Werden die nicht gestörten Zweige mehr als 50% entladen, so daß z. B. die Teilspannungen je 49 Volt betragen, so bleibt die Differenzspannung $U_{12}=1$ Volt ebenfalls erhalten.

Die Fehlerdiskussion zeigt, daß abhängig von der Art des Fehlers und der Belastungsart sich unterschiedliche Spannungen zwischen den Mittelabgriffen einstellen. Hierdurch ist zum einen die Fehlerart und zum anderen der Ort des Defektes feststellbar.

**Patentansprüche**

1. Überwachungseinrichtung für eine Batterie, insbesondere einen Akkumulator mit wässrigen Elektrolyten oder eine Hochenergiebatterie, mit wenigstens zwei parallel geschalteten Zweigen, die jeweils aus Zellreihen mit m+n Zellen bestehen, und m und n beliebige natürliche Zahlen größer als 1 sind, wobei an zu überwachende Zellreihen der Batterie eine elektrische Meßleitung (16, 17, 18, 19, 27, 28) angeschlossen ist, die mit einer Schaltanordnung zur Messung einer Differenzspannung in Verbindung steht, dadurch gekennzeichnet, daß in jeder der parallel geschalteten Zellreihen (A, B, C, D) wenigstens ein Mittelabgriff (1, 2, 3, 4) für eine Meßleitung (16, 17, 18, 19, 27, 28) jeweils zwischen der m-ten und n-ten Zelle angeschlossen ist, daß innerhalb der Batterie jeweils zwei Zellreihen (A, B, C, D) über jeweils zwei hochohmige Widerstandselemente (29) miteinander verbunden sind und daß der Verbindungspunkt (30, 31) der Widerstandselemente jeweils über eine weitere Meßleitung (27, 28) an der Batterie herausgeführt und mit der Schaltungsanordnung verbunden ist.

2. Überwachungseinrichtung nach Anspruch 1, dadurch gekennzeichnet, daß in jeder der parallel geschalteten Zellreihen (A, B, C, D) wenigstens ein Mittelabgriff (1, 2, 3, 4) für eine Meßleitung (16, 17, 18, 19, 27, 28) angeschlossen ist.

3. Überwachungseinrichtung nach Anspruch 1 oder 2, dadurch gekennzeichnet, daß m gleich n ist.

4. Überwachungseinrichtung nach einem der Ansprüche 1 bis 3, dadurch gekennzeichnet, daß jede Meßleitung (16, 17, 18, 19) durch wenigstens ein gegenüber dem Innenwiderstand der Batteriezellen hochohmiges Widerstandselement (20, 29) unterteilt ist.

5. Überwachungseinrichtung nach einem der Ansprüche 1 bis 4, dadurch gekennzeichnet, daß alle Meßleitungen (16, 17, 18, 19), gegebenenfalls inklusiv der Widerstandselemente (20, 29), den gleichen ohmschen Widerstand aufweisen.

6. Überwachungseinrichtung nach Anspruch 6, dadurch gekennzeichnet, daß die Meßleitung (16, 17, 18, 19) einer Zellreihe (A, B, C, D) mit mehreren Differenzverstärkern (23, 24, 25, 26) verbunden ist, an deren jeweils zweiten Eingang Meßleitungen verschiedener anderer Zellreihen (A, B, C, D) angeschlossen sind.

7. Überwachungseinrichtung nach einem der Ansprüche 1 bis 7, dadurch gekennzeichnet, daß innerhalb der Batterie die Meßleitungen zweier Zellreihen (A, B, C, D), in denen jeweils ein gegenüber dem Widerstandswert einer Zelle hochohmiges Widerstandselement (29) liegt, miteinander verbunden sind und daß der Verbindungspunkt (30, 31) über eine weitere Meßleitung (27, 28) aus der Batterie herausgeführt und mit einer Schaltungsanordnung zur Messung einer Differenzspannung verbunden ist.

**Revendications**

1. Dispositif de contrôle d'une batterie, en particulier d'un accumulateur à électrolyte aqueux ou d'une batterie à haute énergie, avec au moins deux branches montées en parallèle, qui consistent chacune en une rangée de cellules avec m+n cellules, m et n étant des nombres naturels quelconques supérieurs à 1, dispositif dans lequel une ligne de mesure électrique (16, 17, 18, 19, 27, 28) est raccordée aux rangées de cellules à surveiller de la batterie, ligne de mesure qui est en liaison avec un montage pour la mesure d'une tension différentielle, caractérisé en ce que, dans chacune des rangées de cellules (A, B, C, D) montées en parallèle, est montée au moins une prise médiane (1, 2, 3, 4) pour une ligne de mesure (16, 17, 18, 19, 27, 28) à chaque fois entre les m cellules et les n cellules, en ce que, à l'intérieur de la batterie, à chaque fois deux rangées de cellules (A, B, C, D) sont reliées entre elles par à chaque fois deux éléments résistants (29) à résistance élevée et en ce que le point de liaison (30, 31) des éléments résistants est à chaque fois conduit à l'extérieur sur la batterie par l'intermédiaire d'une autre ligne de mesure (27, 28) et relié au montage.

2. Dispositif de contrôle selon la revendication 1, caractérisé en ce que, dans chacune des branches de cellules (A, B, C, D) montées en parallèle, est montée au moins une prise médiane (1, 2, 3, 4) pour une ligne de mesure (16, 17, 18, 19, 27, 28).

3. Dispositif de contrôle selon la revendication 1 ou 2, caractérisé en ce que m est égal à n.

4. Dispositif de contrôle selon l'une des revendications 1 à 3, caractérisé en ce que chaque ligne de mesure (16, 17, 18, 19) est subdivisée par au moins un élément résistant (20, 29) ayant une résistance élevée par rapport à la résistance interne des cellules de la batterie.

5. Dispositif de contrôle selon l'une des revendications 1 à 4, catactérisé en ce que toutes les lignes de mesure (16, 17, 18, 19), y compris éventuellement les éléments résistants (20, 29), présentent la même résistance ohmique.

6. Dispositif de contrôle selon l'une des revendications 1 à 5, caractérisé en ce que la ligne de mesure (16, 17, 18, 19) d'une rangée de cellules (A, B, C, D) est reliée à plusieurs amplificateurs différentiels (23, 24, 25, 26), dont la deuxième entrée est à chaque fois raccordée à des lignes de mesure de diverses autres rangées de cellules (A, B, C, D).

7. Dispositif de contrôle selon l'une des revendications 1 à 6, caractérisé en ce que, à l'intérieur de la batterie, les lignes de mesure de deux rangées de cellules (A, B, C, D), dans lesquelles se trouve à chaque fois un élément résistant (29) ayant une résistance élevée par rapport à la résistance interne d'une cellule, sont reliées ensemble et en ce que le point de liaison (30, 31) est conduit à l'extérieur de la batterie par une autre ligne de mesure (27, 28) et est relié au montage pour la mesure d'une tension différentielle.

**Claims**

1. Monitoring device for a battery,-particularly an accumulator with aqueous electrolytes or a high-energy battery, having at least two parallel-connected branches which in each case consist of cell rows with m+n cells, and m and n are arbitrary natural numbers greater than 1, an electrical measuring line (16, 17, 18, 19, 27, 28), which is connected to a circuit arrangement for measuring a differential voltage, being connected to cell rows to be monitored of the battery, characterized in that each of the parallel-connected cell rows (A, B, C, D), at least one centre tap (1, 2, 3, 4) for a measuring line (16, 17, 18, 19, 27, 28) is in each case connected between the mth and nth cell, that inside the battery in each case two cell rows (A, B, C, D) are connected to one another via in each case two high-impedance resistance elements (29), and that the junction (30, 31) of the resistance elements is in each case brought out at the battery via a further measuring line (27, 28) and is connected to the circuit arrangement.

2. Monitoring device according to Claim 1, characterized in that in each of the parallel-connected cell rows (A, B, C, D), at least one centre tap (1, 2, 3, 4) for a measuring line (16, 17, 18, 19, 27, 28) is connected.

3. Monitoring device according to Claim 1 or 2, characterized in that m is equal to n.

4. Monitoring device according to one of Claims 1 to 3, characterized in that each measuring line (16, 17, 18, 19) is subdivided by at least one resistance element (20, 29) which has a high impedance compared with the internal resistance of the battery cells.

5. Monitoring device according to one of Claims 1 to 4, characterized in that all measuring lines (16, 17, 18, 19), possibly including the resistance elements (20, 29) have the same ohmic resistance.

6. Monitoring device according to Claim 5, characterized in that the measuring line (16, 17, 18, 19) of a cell row (A, B, C, D) is connected to several differential amplifiers (23, 24, 25, 26), to the respective second input of which measuring lines of various other cell rows (A, B, C, D) are connected.

7. Monitoring device according to one of Claims 1 to 6, characterized in that inside the battery the measuring lines of two cell rows (A, B, C, D), in which in each case a resistance element (29) is located which has a high impedance compared with the resistance value of a cell, are connected to one another and that the junction (30, 31) is brought out of the battery via a further measuring line (27, 28) and is connected to a circuit arrangement for measuring a differential voltage.

Fig.1

Fig.4

Fig.5

Fig.6